# EUROPEAN PATENT APPLICATION

(11) **EP 4 579 394 A1**
(43) Date of publication of application: **02.07.2025**
(21) Application number: 24191419.1
(22) Date of filing: 29.07.2024
(51) Int. Cl.: G06F 1/3225, G06F 3/06

(54) **STORAGE DEVICE AND OPERATION METHOD THEREOF**

(30) Priority: 26.12.2023 KR 20230191462
(71) Applicant: SAMSUNG ELECTRONICS CO., LTD., Yeongtong-gu Suwon-si, Gyeonggi-do 16677 (KR)
(72) Inventor: JEONG, Myeonghwan, 16677 Suwon-si, Gyeonggi-do (KR); CHEONG, Wooseong, 16677 Suwon-si, Gyeonggi-do (KR); PARK, Ikkyun, 16677 Suwon-si, Gyeonggi-do (KR); LEE, Dahye, 16677 Suwon-si, Gyeonggi-do (KR)
(74) Representative: Kuhnen & Wacker Patent- und Rechtsanwaltsbüro PartG mbB

(57) **Abstract**

A storage device 101 includes a plurality of memory devices 120 and a storage controller 110 receiving a plurality of commands that operate the plurality of memory devices 120 from an external host device. The storage device 101 determines an operation order of the plurality of memory devices 120 according to the plurality of commands based on a power consumption profile table including a power information indicating a power consumption of each of the plurality of memory devices 120.

## Description

### BACKGROUND

The present disclosure relates to a storage device and an operation method thereof.

A storage device is a memory device that may record a data and read it when necessary. The storage device may include a non-volatile memory (NVM), in which a stored data is not destroyed even if a power is not supplied, and a volatile memory (VM), in which a stored data is destroyed if a power is not supplied.

Meanwhile, recently, with a high-capacity and higher integration of the storage devices, a demand for low power is increasing, and a power management for the storage devices has become an important issue.

### SUMMARY

In general, according to some aspects, the present disclosure is directed to a storage device and an operation method thereof that perform a power management based on characteristics of a die.

In general, according to some aspects, the present disclosure is directed to a storage device and an operation method for effectively operating a memory device within a limited power budget.

An example storage device may include a plurality of memory devices, and a storage controller configured to receive a plurality of commands that operate the plurality of memory devices from an external host device, and determine an operation order of the plurality of memory devices according to the plurality of commands based on the power consumption profile table including a power information indicating a power consumption of each of the plurality of memory devices.

An example operation method of a storage device may include receiving a plurality of commands from an external host device and determining a priority of the plurality of commands, comparing the real-time power consumption of the plurality of memory device and the power budget of the storage device, and obtaining the marginal power of the storage device, and determining the operation order of the plurality of commands based on a power consumption profile table including the marginal power and a power information representing the power consumption of each of the plurality of memory devices.

An example storage system may include a power supply that supplies a power voltage input from an outside, a plurality of non-volatile memory devices configured to store a plurality of data input from the outside, and a storage controller configured to create a power consumption profile table representing the power consumption of the plurality of non-volatile memory devices based on the characteristic of the plurality of non-volatile memory devices, and determine the operation order of the plurality of non-volatile memory devices based on the comparison results of the power voltage and a real-time power consumption of the plurality of non-volatile memory devices and the power consumption profile table when receiving a plurality of commands from the outside instructing to save the plurality of data.

### BRIEF DESCRIPTION OF THE DRAWINGS

FIG. 1 is a schematic block diagram of an example storage system.
FIG. 2 is a schematic block diagram of an example storage device.
FIG. 3 is a view to explain an example power management unit.
FIG. 4 is a flowchart to explain an operation method of a power table generator.
FIG. 5 is a view to explain an operation method of a power table generator.
FIG. 6 is a view showing an exemplary power consumption profile table generated by a power table generator.
FIG. 7 is a flowchart to explain an operation method of a power table generator.
FIG. 8 is a view to explain a scheduler in an example power management unit.
FIG. 9 is a flowchart to explain an operation method of an example power budget calculator.
FIG. 10 is a flowchart to explain an operation method of an example scheduler.
FIG. 11 is a drawing to explain an operation method of an example scheduler.
FIG. 12 is a view to explain an operation method of an example scheduler.
FIG. 13 is a view to explain an operation method of an example scheduler.
FIG. 14 is a view showing a wafer including a plurality of dies.
FIG. 15 is a view that illustratively shows an example storage system including a plurality of dies according to FIG. 14.

### DETAILED DESCRIPTION

In the following detailed description, only certain implementations of the present disclosure have been shown and described, simply by way of illustration.

Accordingly, the drawings and description are to be regarded as illustrative in nature and not restrictive. Like reference numerals designate like elements throughout the specification. In the flowcharts described with reference to the drawings in this specification, the operation order may be changed, various operations may be merged, certain operations may be divided, and certain operations may not be performed.

Additionally, any expressions written as a singular may be interpreted as a singular or in plural, unless explicit expressions such as "one" or "single" are used. Terms including ordinal numbers such as first, second, and the like will be used only to describe various components and are not to be interpreted as limiting these components. The terms are only used to differentiate one component from other components.

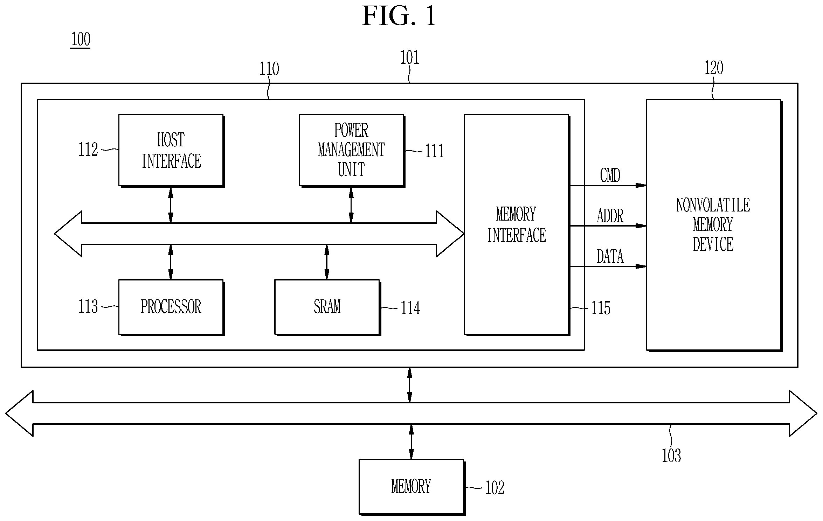

FIG. 1 is a schematic block diagram of a storage system.

The storage system 100 may be a mobile system such as a portable communication terminal (mobile phone), a smart phone, a tablet personal computer (PC), a wearable device, a healthcare device, or an Internet of things (IOT) device. However, it is not limited thereof, and the storage system 100 of FIG. 1 may be a personal computer, a laptop computer, or an automotive equipment such as a navigation, a black box, and automotive electronic devices.

The storage system 100 may include a storage device 101 and a memory 102.

The storage device 101 may be manufactured as one of various types of storage devices according to a host interface, which refers to a transmission protocol with the host device. For example, the storage device 101 may be implemented as a solid state drive (SSD), a smart SSD, an embedded multimedia card (eMMC), an embedded universal flash storage (UFS) memory device, a UFS memory card, a compact flash (CF), a secure digital (SD), a micro-SD (Micro Secure Digital), a Mini-SD (Mini Secure Digital), xD (extreme Digital), a memory stick, or similar forms.

The storage device 101 may include a storage controller 110 and a non-volatile memory device 120. The storage device 101 may store a data DATA or process data DATA according to the request of the host device.

The storage controller 110 can control the operation of the storage device 101. For example, the storage controller 110 may provide an address (ADDR), a command (CMD), etc. to the non-volatile memory device 120 according to the request of the host device. In other words, the storage controller 110 provides signals to the non-volatile memory device 120 to write (program) a data DATA to the non-volatile memory device 120 or read a data DATA from the non-volatile memory device 120.

In some implementations, the storage controller 110 may include a power management unit 111, a host interface 112, a processor 113, SRAM 114, and a memory interface 115.

In some implementations, the power management unit 111 may read characteristic information affecting the power consumption of the non-volatile memory device 120 from the non-volatile memory device 120 and may generate a power consumption profile table based on the characteristic information of the non-volatile memory device 120. In some implementations, the power management unit 111 may generate the power consumption profile table including the power information consumed when the non-volatile memory device 120 operates according to the characteristic information of the non-volatile memory device 120.

In some implementations, the power management unit 111 may obtain a real-time power consumption of the non-volatile memory device 120 and compare the power budget of the storage device 101 and the real-time power consumption of the non-volatile memory device 120. In some implementations, the power management unit 111 may calculate the marginal power of the storage device 101 by comparing the power budget of the storage device 101 and the real-time power consumption of the non-volatile memory device 120.

In some implementations, the storage controller 110 may transmit a plurality of commands to the non-volatile memory device 120 according to a request from the host device. The storage controller 110 may determine the priority of the plurality of commands. In some implementations, the power management unit 111 may determine the operation order of the non-volatile memory device 120 based on the power consumption profile table. In some implementations, the power management unit 111 may further consider the marginal power of the storage device 101 and a predetermined scheduling policy to determine the operation order of the non-volatile memory device 120. The power management unit 111 may change the operation order of the plurality of commands according to the power consumption profile table and the marginal power of the non-volatile memory device 120 based on the predetermined scheduling policy.

The host interface 112 may transmit and receive packets with the host device. The packet transmitted from the host device to the host interface 112 may include a command or a data to be written to the non-volatile memory device 120. The packet transmitted from the host interface 112 to the host device may include a response to a command or a data read from the non-volatile memory device 120. Illustratively, the host interface 112 may communicate with the host device.by using one among standard transmission protocols such as a universal serial bus (USB), a universal flash storage (UFS), a multimedia card (MMC), a parallel advanced technology attachment (PATA), a serial advanced technology attachment (SATA), a small computer system interface (SCSI), a serial attached SCSI (SAS), a peripheral component interconnection (PCI), a PCI express (PCI-E).

The processor 113 may control the overall operation of the storage controller 110. The processor 113 may operate various firmware/software necessary to control the non-volatile memory device 120. For example, the processor 113 may operate a flash conversion layer to manage a mapping table that defines a relationship between a logical address and a physical address of the non-volatile memory device 120.

The processor 113 may process requests received from the host device. The processor 113 may operate an instruction or an algorithm in a form of a code loaded in the SRAM 114, that is, software, to process the request received from the host device, and may control internal functional blocks and the non-volatile memory device 120. The processor 113 may include a central processing unit (CPU), a controller, or a custom semiconductor (an application specific integrated circuit, ASIC). In some implementations, the SRAM 114 may receive the power consumption profile table from the power management unit 111 and store it.

The non-volatile memory device 120 may include a plurality of dies, or a plurality of chips, including a memory cell array. For example, the non-volatile memory device 120 includes a plurality of die groups, and each of the plurality of die groups may include a plurality of dies. In some implementations, the non-volatile memory device 120 may also include a plurality of channels, each of which includes a plurality of dies.

The non-volatile memory device 120 may include a NAND flash memory. In another implementation, the non-volatile memory device 120 may be an electrically erasable programmable read-only memory (EEPROM), a phase change random access memory (PRAM), a resistive RAM (ReRAM), a resistance random access memory (RRAM), and a nano floating memory gate memory (NFGM), a polymer random access memory (PoRAM), a magnetic random access memory (MRAM), a ferroelectric random access memory (FRAM), or similar memories thereto.

The memory 102 may be used as a main memory device of the storage system 100 and may include a volatile memory such as a SRAM and/or a DRAM but may also include a non-volatile memory such as a flash memory. The memory 102 may be connected to the storage device 101 through a bus 103. In some implementations, the memory 102 may receive the power consumption profile table from the storage device 101 and store it.

Meanwhile, In FIG. 1, one storage device 101 is shown as including one non-volatile memory device 120, but the present disclosure is not limited thereto and the storage device 101 may include a plurality of non-volatile memory devices.

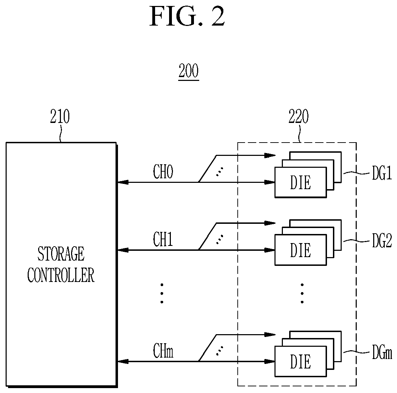

FIG. 2 is a schematic block diagram of a storage device.

The storage device 200 may include a storage controller 210 and a non-volatile memory device 220. The non-volatile memory device 220 may include a plurality of die groups DG1, ..., DGm. The plurality of die groups DG1, ..., DGm may respectively include a plurality of dies DIE. The channels CH1, ..., CHm for the connection with the storage controller 210 may be provided in a number corresponding to the number of the plurality of die groups DG1, ..., DGm, but is not limited thereto. One channel may be shared by the plurality of dies DIE. The die DIE may be a NAND flash memory device.

In some implementations, the power consumed by the plurality of dies DIE may be different. Specifically, the power consumption of the plurality of dies DIE may be different depending on the characteristics of each die DIE. The characteristics of the die DIE that affect the power consumption of the die DIE may include process variables, temperatures, voltages, etc.

Here, the process variables are a variable for the process of manufacturing the die DIE and may be determined based on a process deviation information for the die DIE.

The storage controller 210 according to an implementation may generate the power consumption profile table including the power consumption of the die according to the characteristics of each die, and efficiently manage the power budget of the storage device based on the power consumption profile table and the marginal power of the storage device.

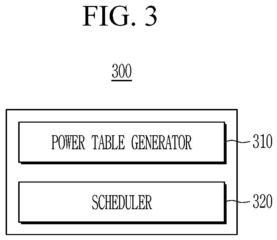

FIG. 3 is a view to explain an example power management unit. In some implementations, the storage controller (referring to 110 in FIG. 1) may include a power management unit 300 to efficiently manage the power budget of the storage device.

In some implementations, the power management unit 300 may include a power table generator 310 and a scheduler 320.

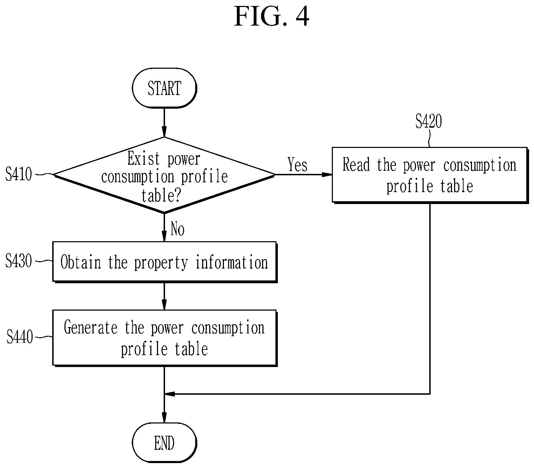

In some implementations, the power table generator 310 may generate a power consumption profile table including a power information indicating a power consumption of a plurality of dies connected to the storage controller 110. The specific operation method of the power table generator 310 is described together with reference to FIG. 4.

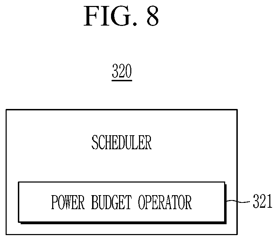

In some implementations, the scheduler 320 may determine the operation order of the plurality of dies based on the power consumption profile table. The detailed description of the scheduler is described with reference to FIG. 8 to FIG. 12 later.

FIG. 4 is a flowchart to explain an operation method of a power table generator.

In some implementations, the power table generator 310 checks whether a previously generated power consumption profile table is present (S410), and if there is no previously generated power consumption profile table, obtains a characteristic information of the die to generate the power consumption profile table (S430).

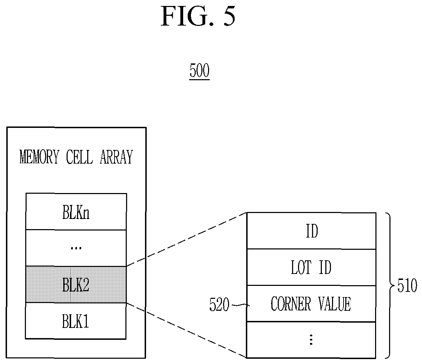

Referring together to FIG. 5, FIG. 5 is a view to explain an operation method of a power table generator. Specifically, this is a drawing to explain how the power table generator 310 according to an implementation acquires the characteristic information of the die to generate the power consumption profile table.

In some implementations, the die may include a memory cell array 500. The memory cell array 500 may include a plurality of memory blocks BLK1, ..., BLKn. Each of the plurality of memory blocks BLK1, ..., BLKn may include a plurality of memory cells. The plurality of memory cells may store the data DATA received from the outside based on external control signals.

In some implementations, some of the plurality of memory blocks BLK1, ... , BLKn of the memory cell array 500 may store a general user data, and others may store a security data 510 of the die. Among the plurality of memory blocks BLK1, ..., BLKn of the memory cell array 500, the block BLK2, where the security data 510 is stored, may be referred to as a security block. Here, the security data 510 is shown as being stored in some blocks of the plurality of memory blocks, but it is not limited thereto, and the security data 510 may be stored in some regions of the memory cell array 500 or in an internal logic such as an e-fuse. Additionally, the security data 510 may be a data that may be programmed only once. The security data 510 may be programmed only once, and once programmed the data may be safely protected from any external manipulation.

In some implementations, the security data 510 may include an ID of a die, that is, a memory device, a lot ID, and a corner value. Specifically, the die ID may include a serial number of a manufacturer, a manufacturing date, etc., and the lot ID may refer to an ID assigned to a wafer during the manufacturing process of the die. The corner value 520 is a characteristic information about the die and may be a process variable for the die DIE. In some implementations, the power table generator 310 may obtain the corner value 520 as the characteristic information of the die from the memory cell array 500 inside the die and use the corner value 520 to generate the power consumption profile table.

In some implementations, the corner value 520 may be one of the characteristics of the die that affects the power consumption of the die. Specifically, the corner value of 520 may be determined according to the characteristics of the P-type/N-type transistor that makes up the memory cell inside the die. For example, regarding the P-type/N-type transistor that constitutes the memory cell, the P-type transistor may be fast, slow, or nominal, and the N-type transistor may be fast, slow, or general. That is, the corner value 520 may be determined according to the operation speed of the memory cell, which is determined differently depending on the characteristics of the P-type/N-type transistor constituting the memory cell. At the process stage where the die is mass-produced, the corner value 520 of the die may be determined according to the characteristics of the cells inside the die. Here, the corner value is explained as a process variable, but it is not limited to this, and the power table generator 310 may further consider various characteristics that affect the power consumption of the die.

In some implementations, the power table generator 310 may measure and obtain the operation time of each die as the characteristic information of the die. For example, depending on the characteristics of the P-type/N-type transistors that make up the memory cell inside the die, if both P-type/N-type transistors are fast, there are trends that the operation speed is fast and the power consumption is high. Conversely, if both P-type/N-type transistors are slow, there are trends that the operation speed is slow and the power consumption is low. Therefore, the power table generator 310 may obtain the operation time as the characteristic information of the die.

In some implementations, the power table generator 310 may generate the power profile table based on the characteristic information of the die (S440).

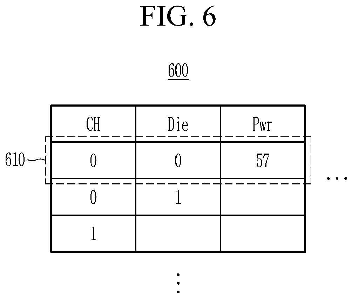

Referring to FIG. 6 together, FIG. 6 is a view showing an example power consumption profile table generated by a power table generator.

In some implementations, the power consumption profile table 600 may include the power information consumed by each die (referring to DIE in FIG. 2) in the plurality of die groups (referring to DG1, ..., DGm in FIG. 2) connected to the storage controller (referring to 210 in FIG. 2). In detail, the power consumption profile table 600 may include a channel information CH, a die information Die, and a power information Pwr, to which each die DIE connected to the storage controller 210 is connected. For example, the second row 610 of the power consumption profile table 600 may indicate the power consumed by the first die (Die 0) connected to the first channel CH0 among the plurality of channels CH0, ..., CHm connected to the storage controller 210. Here, the numbers indicated as the channel information CH, the die information Die, and the power information Pwr are for better understanding and ease of description, but it is not limited to this, and the channel to which each die is connected, the die information, and the power information may be expressed in various formats. Additionally, the power information Pwr may be expressed as an absolute value of the power consumed by the corresponding die, or as a relative value in relationships with other dies.

In some implementations, the power information Pwr may be a value generated based on the characteristic information of the die. For example, the power information Pwr may be a value generated based on the corner value of the die or the operation time of the die. In some implementations, the power table generator 310 may obtain the power information Pwr of the die by calculating according to a predetermined calculation method based on the characteristic information of the die. Here, the predetermined calculation method may differ depending on each manufacturer or each product of the die, that is, the memory device. In some implementations, the power information Pwr may further consider other characteristic information of the die.

In some implementations, the power table generator 310 may generate the power consumption profile table 600 and store the generated power consumption profile table 600 in the SRAM (referring to 114 in FIG. 1) in the storage controller (referring to 110 in FIG. 1). Alternatively, the power table generator 310 may generate the power consumption profile table 600 and store the generated power consumption profile table 600 in an external memory (referring to 102 in FIG. 1).

In some implementations, if there is the power consumption profile table already created in the SRAM 114 or the external memory 102 in the storage controller 110, the power table generator 310 does not regenerate the power consumption profile table, but it may read the power consumption profile table existed in the SRAM 114 or the external memory 102 (S420).

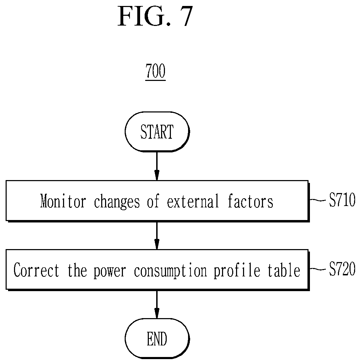

FIG. 7 is a flowchart to explain an operation method of a power table generator. Specifically, the power consumption of the die may vary depending on various factors. Therefore, FIG. 7 is the flowchart to explain how the power table generator corrects the power information Pwr of the power consumption profile table by considering external factors.

In some implementations, the power table generator may detect changes in the external factors (S710). Here, the external factors are factors that affect the power consumption of the die and may include a surrounding temperature, an access frequency for the die, etc. In one implementation, the power table generator may detect the changes in the external factors that affect the power consumption of the die by monitoring the external factors at a predetermined time period. Alternatively, the power table generator may continuously detect the changes in the external elements through sensors to detect the changes in the external elements.

In one implementation, the power table generator may monitor the changes in the surrounding temperature of the die. For example, when the surrounding temperature of the die increases, the power consumption of the die increases, and when the surrounding temperature of the die decreases and approaches a normal temperature (or a room temperature), the power consumption of the die may decrease. The power table generator may monitor the surrounding temperature of the die with a predetermined time period. Alternatively, the power table generator may continuously monitor the changes in the surrounding temperature through a sensor (e.g., a temperature sensor) to detect the changes in the surrounding temperature of the die.

In some implementations, the power table generator may monitor the access frequency for the die. The access frequency to the die may mean the number of times that a read/write operation is performed on the die, that is, a memory device. For example, as the read/write operations on the memory devices occur frequently, due to heat generated in the circuit inside the memory device, the temperature may increase and the power consumption of the memory device may increase. The power table generator may monitor the access frequency to the die with the predetermined time period or continuously.

In some implementations, the power table generator may correct the power consumption profile table (S720). Specifically, the power table generator may correct the power information Pwr of the power consumption profile table based on the changes in the external factors to obtain the more accurate power consumption of the die.

In some implementations, the power table generator may correct the power information in the power consumption profile table according to a predetermined calculation method based on the changes in the external factors. For example, when the external temperature of the die increases, the power table generator may monitor the external temperature and correct the power information in the power consumption profile table according to a predetermined calculation method. Alternatively, when the access frequency to the die increases, the power table generator may monitor the access frequency and correct the power information in the power consumption profile table according to a predetermined calculation method. Here, the predetermined calculation method may differ depending on each manufacturer or each product of the die, that is, the memory device. Here, the surrounding temperature and the access frequency to the die are explained as examples of the external factors, but they are not limited thereto, and the power table generator may further consider various external factors that affect the power consumption of the die.

FIG. 8 is a view to explain a scheduler within a power management unit.

In some implementations, the scheduler 320 may determine the operation order of the plurality of dies based on the power consumption profile table. Specifically, the storage controller may transmit the plurality of commands to the plurality of dies according to the request of the external host device. At this time, depending on the priority of the plurality of commands, the die that will execute the command may be determined. In some implementations, the scheduler 320 may change the operation order of the plurality of commands based on the power consumption profile table.

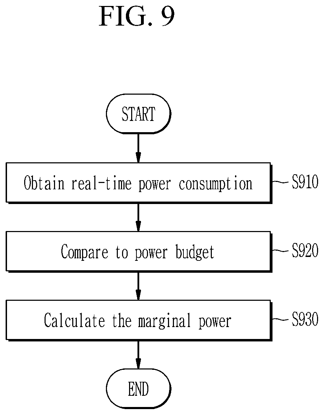

In some implementations, the scheduler 320 may include a power budget calculator 321. The power budget calculator 321 may calculate the marginal power based on the real-time power consumption and the power budget of the plurality of dies. The specific operation method of the power budget calculator 321 is described with reference to FIG. 9.

FIG. 9 is a flowchart to explain an operation method of a power budget calculator.

In some implementations, the power budget calculator 321 may obtain the real-time power consumption of the die (S910). The power budget calculator may obtain the real-time power consumption of each of the plurality of dies connected to the storage controller. The power budget calculator may determine the die currently in the operation among the plurality of dies connected to the storage controller and obtain the real-time power consumption of the die currently in the operation.

In some implementations, the power budget calculator may compare the real-time power consumption of the die and the power budget of the storage device (S920) and calculate the marginal power of the storage device based on the comparison results (S930). In some implementations, the power budget calculator may determine the value excluding the real-time power consumption of the current die from the power budget of the storage device as the marginal power of the storage device, but it is not limited thereto.

In some implementations, the scheduler 320 may obtain the marginal power from the power budget calculator and determine the operation order of the plurality of die based on the power consumption profile table.

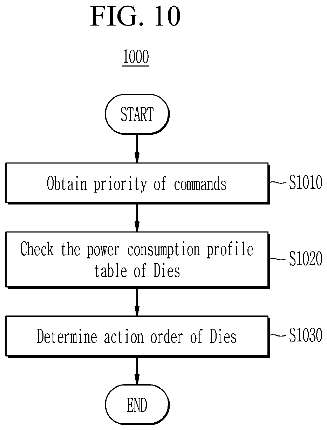

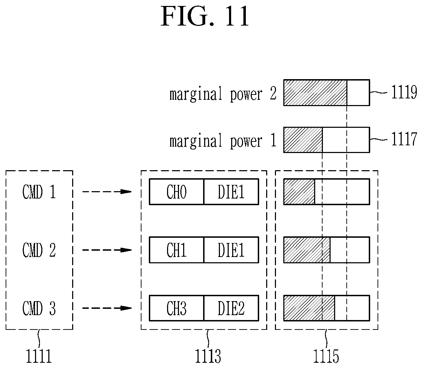

FIG. 10 is a flowchart to explain an operation method of a scheduler. FIG. 11 to FIG. 13 are views to explain an operation method of a scheduler.

In some implementations, the scheduler may obtain the priority of the commands (S1010). In some implementations, the storage controller may determine the operation order of the commands based on the priority of the command. Specifically, the storage controller may receive a plurality of commands according to a request from an external host device and determine the priority of the plurality of commands. The priority of each command may be determined according to the operation type of the command, the type of the data, the importance of the data, etc. In some implementations, the priorities of some commands among the plurality of commands may be the same. Referring to FIG. 11 together, the priorities of plurality of commands CMD1, CMD2, and CMD3 may be the same. The storage controller may determine that the priorities of the plurality of commands CMD1, CMD2, and CMD3 are the same, considering the operation type of the command, the type of the data, and the importance of the data.

In some implementations, the scheduler may check the power consumption profile table of the die (S1020). Specifically, the scheduler may check the power consumption profile table to obtain the power information of the plurality of dies that will perform the operation corresponding to the command, based on the priority of the plurality of commands. Referring to FIG. 11 together, the plurality of commands CMD1, CMD2, and CMD3 may be commands to perform the specific operation for the specific die. For example, the first command CMD1 may be a command to perform a read operation on the second die DIE connected to first channel CH0, and the second command CMD2 may be a command to perform a read operation on the second die DIE connected to the second channel CH1, but it is not limited thereto. In some implementations, the scheduler can check the power consumption profile table of the dies 1113 corresponding to the plurality of commands CMD 1, CMD2, and CMD3. In some implementations, the scheduler may obtain a power information 1115 indicating the power consumption consumed when the corresponding dies operate from the power consumption profile table of the dies 1113 corresponding to the plurality of commands CMD1, CMD2, and CMD3.

In some implementations, the scheduler may determine the operation order of the plurality of dies (S1030). Specifically, the scheduler may determine the operation order of the plurality of dies based on the power consumption of the dies. In some implementations, the scheduler may further consider the predetermined scheduling policy and the marginal power when determining the operation order of the plurality of dies.

Referring to FIG. 11,In some implementations, the scheduler may determine the operation order of the plurality of dies 1113 based on the power information 1115 indicating the power consumption of the plurality of dies 1113. For example, the scheduler may determine to first perform the operation of the die (e.g., the second die DIE1 connected to the first channel CH0) with the lowest power consumption among the plurality of dies 1113 corresponding to the plurality of commands 1111 with the same priority. Or, based on the power information 1115 indicating the power consumption of the plurality of dies 1113, the scheduler may determine to perform first the operation of the die (e.g., third die DIE2 connected to fourth channel CH3) with the highest power consumption among the plurality of dies 1113 corresponding to the plurality of commands 1111 with the same priority.

In some implementations, the scheduler may further consider the marginal power according to a predetermined scheduling policy to determine the operation order of the plurality of dies 1113. Specifically, among the plurality of dies corresponding to the plurality of commands with the same priority, it may be decided to operate first the die which consumes less power than the marginal power.

In some implementations, there may be one die that consumes less power than the marginal power. For example, if the marginal power of the storage device is a first marginal power (a marginal power 1; 1117), among the plurality of dies 1113 corresponding to the plurality of commands 1111, there may be only one die that consumes less power than the first marginal power 1117. (e.g., a second die DIE1 connected to the first channel CH0). The scheduler may decide to perform first the operation of the second die DIE1 connected to the first channel CH0 according to a predetermined scheduling policy.

In some implementations, there may be multiple dies that consume less the power than the marginal power. For example, if the marginal power of the storage device is a second marginal power (a marginal power 2; 1119), there may be multiple dies that consume less power than the second marginal power 1119 among the plurality of dies 1113 corresponding to the plurality of commands 1111 (e.g., a second die DIE1 connected to a first channel CH0, a second die DIE connected to a second channel CH1, and a third die DIE2 connected to a fourth channel CH3). According to a predetermined scheduling policy, the scheduler may decide to perform first the operation of the die (e.g., a third die DIE2 connected to a fourth channel CH3) with the higher power consumption among the dies consuming less power than the second marginal power 1119, but it is not limited to this. In some implementations, if the marginal power of the storage device is the second marginal power 1119, according to the predetermined scheduling policy, the scheduler may decide to perform first the operation of the die with the lower power consumption (e.g., the second die DIE1 connected to the first channel CH0) among the dies consuming less power than the second marginal power 1119.

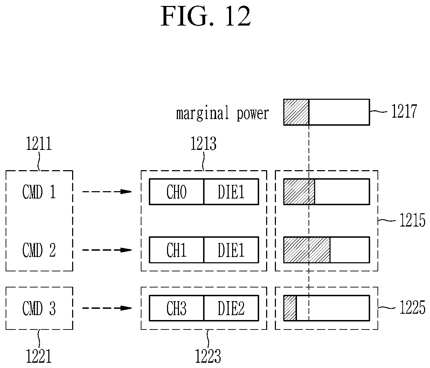

In some implementations, there may not be a die that consumes less power than the marginal power. The operation method of the scheduler for this is described with reference to FIG. 12.

FIG. 12 is a view to explain an operation method of a scheduler according to an additional embodiment.

In some implementations, the scheduler may obtain the operation order of the command based on the priority of the command. In some implementations, the priorities of the plurality of commands may be different. Referring to FIG. 12, the priorities of the first command CMD1 and the second command CMD2 among the plurality of commands may be the same, and the priority of the third command CMD3 among the plurality of commands may be lower than the priorities of the first command CMD1 and the second command CMD2. For example, among the plurality of commands, the first command CMD1 and the second command CMD2 may be commands for performing the same operation, and the third command CMD3 among the plurality of commands may be a command for performing a different operation from the first command CMD1 and the second command CMD2, but it is not limited thereto. Hereinafter, the first command CMD1 and the second command CMD2 are referred to as a first priority command 1211, and the third command CMD3 is referred to as a second priority command 1221.

In some implementations, the scheduler may check the power consumption profile table and obtain the power information 1215 indicating the power consumption of the dies 1213 that will perform the operation corresponding to the first priority command 1211. In some implementations, the scheduler may determine that there is no die consuming less the power than the marginal power 1217 among the power information 1215 of the dies 1213 that will perform the operation corresponding to the first priority command 1211.

In some implementations, the scheduler may determine the operation order of the plurality of dies based on the plurality of die power information. In some implementations, the scheduler may consider a predetermined scheduling policy to determine the operation order of the plurality of dies. In some implementations, the predetermined scheduling policy may differ depending on Quality of Service (QoS) conditions. For example, the high priority operations may be performed first, or the operation of the die with the low power consumption may be performed first.

In some implementations, if it is determined that there is no die consuming less the power than the marginal power 1217 based on the power information 1215 of the dies 1213, the scheduler may wait until the marginal power 1217 exceeds one of the power information 1215 according to a predetermined scheduling policy. For example, the marginal power 1217 may increase as the currently performing operation ends or is aborted. In some implementations, it compares the power information of the plurality of memory devices with the marginal power of the storage device based on the power consumption profile table, determines that the plurality of memory devices are consuming more power that the marginal power, and waits until the marginal power exceeds the power information of one or more memory devices of the plurality of memory devices.

Also, in some implementations, if it is determined that there is no die consuming less power than the marginal power 1217 based on the power information 1215 of the dies 1213, the scheduler may check the power consumption profile table of the die 1223, which will perform the operation corresponding to the second priority command 1221, according to a predetermined scheduling policy, and obtain the power information 1225 indicating the power consumption of die 1223. In some implementations, the scheduler may determine that the power information 1225 of the die 1223 that will perform the operation corresponding to the second priority command 1221 is less than the marginal power 1217 and determine that the second priority command 1221 will be performed first. In some implementations, it compares the power information of the plurality of memory devices with the marginal power of the storage device based on the power consumption profile table, determines that a first plurality of memory devices among the plurality of memory devices is consuming less power that the marginal power, and determines an operation order of the first plurality of memory devices. The operation order of the first plurality of memory devices is in order of a largest power consumption to a smallest real-time power consumption among the first plurality of memory devices.

As described above, the predetermined scheduling policy may determine the operation order of the dies according to the marginal power, so that the die consuming the least power or the die consuming the most power among the dies consuming less power than the marginal power is performed first. In addition, according to the scheduling policy according to the QoS condition, the operation order of the commands may be changed to perform the operations with high priority first or the operations on the dies with low power consumption first. However, the scheduling policy is not limited to this, and various scheduling policies may further exist to efficiently manage the power budget of the storage device.

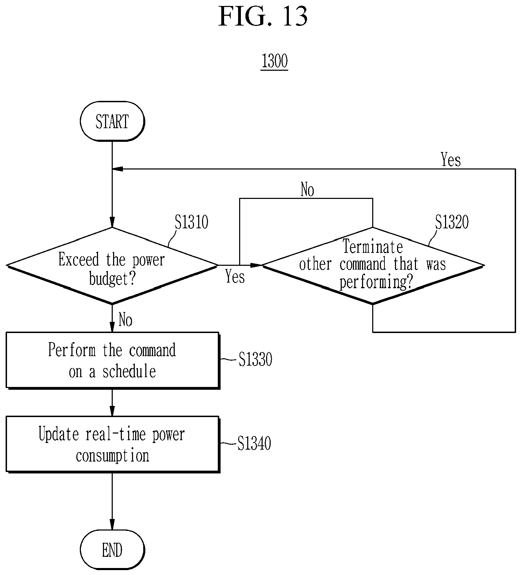

FIG. 13 is a flowchart showing an operation method of a scheduler.

In some implementations, the scheduler may determine whether the real-time power consumption of the dies exceeds the power budget of the storage device (S1310). Specifically, the scheduler may determine the operation order of the commands or the dies according to a predetermined scheduling policy and determine whether the real-time power consumption of the dies exceeds the power budget of the storage device when performing the operation.

In some implementations, if it is determined that the power consumption of the dies exceeds the power budget of the storage device, the scheduler may determine whether other operations currently being performed are terminated (S1320). Also, the scheduler may wait until other operations currently being performed are terminated. If the operation performing continues even though the power consumption of the dies exceeds the power budget of the storage device, this is because it may cause various problems, such as errors in data stored in the die, that is, in the memory device.

In some implementations, if it is determined that the power consumption of the dies does not exceed the power budget of the storage device, the scheduler may perform the command according to the determined operation order (S1330). Alternatively, the same applies to determining that the power consumption of the dies does not exceed the power budget of the storage device as other operations are terminated.

In some implementations, the scheduler may update the real-time power consumption of the dies (S 1340).

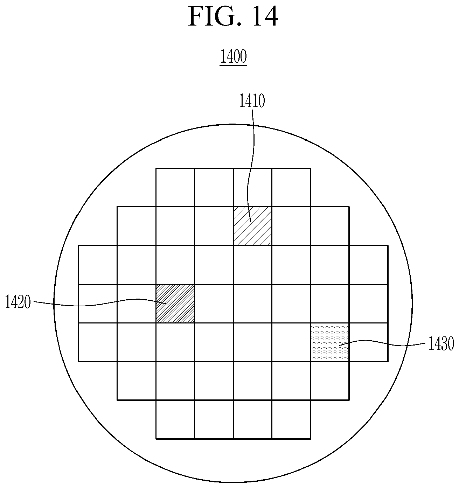

FIG. 14 is a view showing a wafer including a plurality of dies.

One wafer 1400 may produce a plurality of dies 1410, 1420, and 1430. In some implementations, the plurality of dies 1410, 1420, and 1430 may be memory devices. In some implementations, the plurality of dies 1410, 1420, and 1430 may be connected to the same storage controller. In some implementations, the plurality of dies 1410, 1420, and 1430 may receive commands from the same storage controller and perform read/write operations, etc. based on them.

In some implementations, the characteristics of each die 1410, 1420, and 1430 may be different from each other. Here, the die characteristics may include process variables, a temperature, a voltage, etc. Accordingly, the power consumption of each die 1410, 1420, and 1430 may be different. Nevertheless, when applying the same margin to the power consumption of the plurality of dies 1410, 1420, and 1430 generated at one wafer 1400, there is a problem of wasting the power budget for the dies with the low power consumption, and there is a problem that the power consumption exceeds the power budget for the dies with high power consumption, thereby increasing the possibility of errors occurring in the operation.,

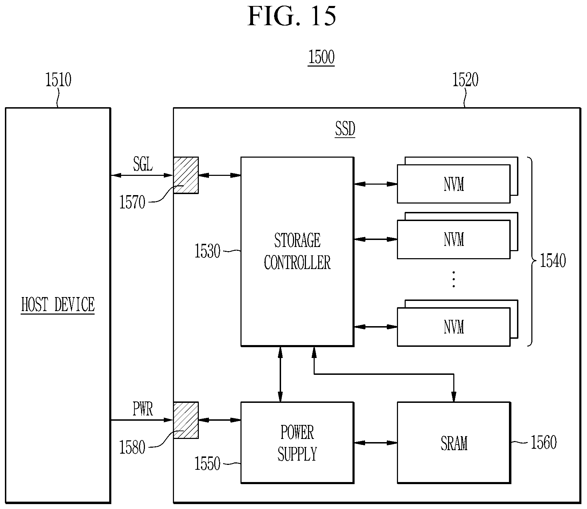

FIG. 15 is a view that illustratively shows an example storage system including a plurality of dies according to FIG. 14. Referring to FIG. 15, the storage system 1500 may include a host device 1510 and a solid state drive 1520 (hereinafter referred to as SSD) including non-volatile memory devices 1540 as a plurality of dies.

The SSD 1520 may include a storage controller 1530, a SRAM 1560, non-volatile memory devices 1540, a power supply 1550, a signal connector 1570, and a power connector 1580.

The non-volatile memory devices 1540 may be used as a storage media for the SSD 1520. Each of the non-volatile memory devices 1540 may be connected to the storage controller 1530 through the plurality of channels CH1, ..., CHn. One or more non-volatile memory devices may be connected to one channel. The non-volatile memory devices connected to one channel may be connected to the same signal bus and data bus. The characteristics of the non-volatile memory devices 1540 may be different.

The power supply 1550 may provide a power PWR input through the power connector 1580 to the inside of the SSD 1520. The power budget of the SSD 1520 may be determined by the power PWR input through the power supply 1550.

The storage controller 1530 may exchange signals SGL with the host device 1510 through the signal connector 1570. Here, the signal SGL may include a command, an address, a data, etc. The signal connector 1570 may be composed of various types of connectors depending on the interface method of the host device 1510 and the SSD 1520.

The storage controller 1530 may control all operations of the SSD 1520. The storage controller 1530 may generate a power information indicating a power consumption of the non-volatile memory devices 1540 based on the characteristics of the non-volatile memory devices 1540. In some implementations, the power information may be stored in the SRAM 1560. The storage controller 1530 according to an implementation may determine the operation order of the non-volatile memory devices 1540 based on the power information of the non-volatile memory devices 1540. By performing a power management for the memory devices based on the characteristics of the non-volatile memory devices 1540, the storage controller 1530 according to an implementation has the advantage of being able to effectively operate the memory devices within a limited power budget.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A storage device (101, 200, 1520) comprising:
a plurality of memory devices (1113, 1213, 1223), and
a storage controller (110, 210, 1530) configured to receive, from an external host device (1510), a plurality of commands (1111, 1211, 1221) that operate the plurality of memory devices (1113, 1213, 1223) and to determine an operation order of the plurality of memory devices (1113, 1213, 1223) according to the plurality of commands (1111, 1211, 1221) based on a power consumption profile table (600) including power information (1115, 1215, 1225) indicating a power consumption of each of the plurality of memory devices (1113, 1213, 1223).

2. The storage device (101, 200, 1520) of claim 1, wherein:
the storage controller (110, 210, 1530) is configured to generate the power consumption profile table (600) including the power information according to a predetermined calculation method based on a characteristic information of each of the plurality of memory devices (1113, 1213, 1223).

3. The storage device (101, 200, 1520) of claim 2, wherein:
the characteristic information is stored in each of the plurality of memory devices (1113, 1213, 1223).

4. The storage device (101, 200, 1520) of claim 2 or 3, wherein:
the storage controller (110, 210, 1530) is configured to correct the power information (1115, 1215, 1225) based on changes in external factors that affect the power consumption of each of the plurality of memory devices (1113, 1213, 1223).

5. The storage device (101, 200, 1520) of any one of claims 1 to 4, wherein:
the storage controller (110, 210, 1530) is configured to acquire a marginal power (1117, 1119, 1217) of the storage device (101, 200, 1520) based on a real-time power consumption of each of the plurality of memory devices (1113, 1213, 1223) and a power budget of the storage device (101, 200, 1520), and is configured to determine the operation order of the plurality of memory devices (1113, 1213, 1223) based on the marginal power (1117, 1119, 1217) and the power consumption profile table (600).

6. The storage device (101, 200, 1520) of claim 5, wherein:
the storage controller (110, 210, 1530) is configured to determine that the power information (1115, 1215, 1225) of a memory device among the plurality of memory devices (1113, 1213, 1223) is less than the marginal power (1117, 1119, 1217) based on the marginal power (1117, 1119, 1217) and the power consumption profile table (600), and to determine the operation order of the plurality of memory devices (1113, 1213, 1223) so that an operation of the memory device among the plurality of memory devices (1113, 1213, 1223) is performed first.

7. The storage device (101, 200, 1520) of claim 5 or 6, wherein:
the storage controller (110, 210, 1530) is configured to:
comparing the power information (1115, 1215, 1225) of the plurality of memory devices (1113, 1213, 1223) with the marginal power (1117, 1119, 1217) of the storage device (101, 200, 1520) based on the power consumption profile table (600);
determine that each of the plurality of memory devices (1113, 1213, 1223) are consuming more power than the marginal power (1117, 1119, 1217); and
wait until the marginal power (1117, 1119, 1217) exceeds the power information (1115, 1215, 1225) of one or more memory devices (1113, 1213, 1223) of the plurality of memory devices (1113, 1213, 1223).

8. The storage device (101, 200, 1520) of any one of claims 5 to 7, wherein:
the storage controller (110, 210, 1530) is configured to:
comparing the power information (1115, 1215, 1225) of the plurality of memory devices (1113, 1213, 1223) with the marginal power (1117, 1119, 1217) of the storage device (101, 200, 1520) based on the power consumption profile table (600);
determine that a first plurality of memory devices (1213) among the plurality of memory devices (1113, 1213, 1223) are consuming less power than the marginal power (1117, 1119, 1217); and
determine an operation order of the first plurality of memory devices (1213),
wherein the operation order of the first plurality of memory devices (1213) is in order of a largest power consumption to a smallest power consumption.

9. A storage system (100, 1500) including the storage device (101, 200, 1520) of any one of claims 1 to 8, the storage system (100, 1500) comprising:
a power supply (1550) that supplies a power input from an outside device,
a plurality of non-volatile memory devices (1540) configured to store a plurality of data input from the outside device, and
a storage controller (110, 210, 1530) configured to:
create a power consumption profile table (600) representing power consumption of the plurality of non-volatile memory devices (1540) based on a characteristic of the plurality of non-volatile memory devices (1540), and
determine an operation order of the plurality of non-volatile memory devices (1540) based on comparison results of the power input and a real-time power consumption of the plurality of non-volatile memory devices (1540) and the power consumption profile table (600) when receiving a plurality of commands (1111, 1211, 1221) from the outside device instructing to save the plurality of data.

10. An operation method of a storage device (101, 200, 1520) comprising:
receiving a plurality of commands (1111, 1211, 1221) from an external host device and determining an operation order of each of the plurality of commands (1111, 1211, 1221),
comparing a real-time power consumption of each of a plurality of memory devices (1113, 1213, 1223) and a power budget of the storage device (101, 200, 1520), and obtaining a marginal power (1117, 1119, 1217) of the storage device (101, 200, 1520), and
determining the operation order of the plurality of commands (1111, 1211, 1221) based on the marginal power (1117, 1119, 1217) and a power consumption profile table (600) including a power information (1115, 1215, 1225) representing a power consumption of each of the plurality of memory devices (1113, 1213, 1223).

11. The operation method of the storage device (101, 200, 1520) of claim 10, further comprising:
acquiring a characteristic information for each of the plurality of memory devices (1113, 1213, 1223), and
creating the power consumption profile table (600) including the power information (1115, 1215, 1225) indicating the power consumption of each of the plurality of memory devices (1113, 1213, 1223) based on the characteristic information of each of the plurality of memory devices (1113, 1213, 1223).

12. The operation method of the storage device (101, 200, 1520) of claim 10 or 11, wherein:
the plurality of commands (1111, 1211, 1221) includes a first plurality of commands (1211) and a second plurality of commands (1221), and
determining the operation order of the plurality of commands (1111, 1211, 1221) comprises:
determining that the operation order of the first plurality of commands (1211) is higher than the operation order of the second plurality of commands (1221).

13. The operation method of the storage device (101, 200, 1520) of claim 12, wherein determining the operation order of the plurality of commands (1111, 1211, 1221) comprises:
obtaining power information (1215) of a first plurality of memory devices (1213) among the plurality of memory devices (1113, 1213, 1223) from the power consumption profile table (600) that is configured to perform operations according to the first plurality of commands (1211), and
comparing the marginal power (1117, 1119, 1217) and the power information (1215) of the first plurality of memory devices (1213).

14. The operation method of the storage device (101, 200, 1520) of claim 13, further comprising:
determining that there is no power information less than the marginal power (1217) among the power information (1215) of the first plurality of memory devices (1213),
obtaining power information (1225) of a second plurality of memory devices (1223) that perform the operations according to the second plurality of commands (1221) from the power consumption profile table (600),
comparing the marginal power (1217) and the power information (1225) of the second plurality of memory devices (1223),
determining that the power information (1225) of a memory device among the second plurality of memory devices (1223) is less than the marginal power (1217), and
determining the operation order of the plurality of commands (1111, 1211, 1221) so that a command corresponding to the memory device among the second plurality of memory devices (1223) is performed first.

15. The operation method of the storage device (101, 200, 1520) of any one of claims 11 to 14, further comprising:
checking whether the real-time power consumption of the plurality of memory devices (1113, 1213, 1223) exceeds the power budget of the storage device (101, 200, 1520),
performing a command according to the plurality of commands (1111, 1211, 1221) based on the determined operation order if the real-time power consumption of each of the plurality of memory devices (1113, 1213, 1223) does not exceed the power budget of the storage device (101, 200, 1520), and
updating the real-time power consumption of the plurality of memory devices (1113, 1213, 1223).
